# EUROPEAN PATENT APPLICATION

(11) **EP 4 764 573 A1**
(43) Date of publication of application: **24.06.2026**
(21) Application number: 24904145.0
(22) Date of filing: 03.12.2024
(51) Int. Cl.: G01R 31/52, G01R 31/392, G01R 31/367, G01R 19/00, G01R 19/10, G01R 19/12

(54) **BATTERY DIAGNOSTIC DEVICE AND OPERATING METHOD THEREOF**

(30) Priority: 15.12.2023 KR 20230183552
(71) Applicant: LG Energy Solution, Ltd., Seoul 07335 (KR)
(72) Inventor: KIM, Ki Hoon, Daejeon 34122 (KR); JUNG, Jin Won, Daejeon 34122 (KR); JANG, Tae Hyeok, Daejeon 34122 (KR); JANG, Jin Woo, Daejeon 34122 (KR)
(74) Representative: Goddar, Heinz J.
(86) International application number: PCT/KR2024/019593
(87) International publication number: WO 2025/127580

(57) **Abstract**

A battery diagnosis apparatus according to an embodiment disclosed herein includes an information obtaining unit configured to obtain a voltage of each of a plurality of battery cells, a voltage deviation calculating unit configured to calculate an average of voltages of the plurality of battery cells and calculate, as a first deviation, a difference between the average and the voltage of each of the plurality of battery cells, and a controller configured to calculate a first variation corresponding to a variation of a first deviation of each of the plurality of battery cells for each first period, calculate a second variation corresponding to a variation of the first deviation of each of the plurality of battery cells for each second period that is different from the first period, and perform abnormality diagnosis on the plurality of battery cells based on the first variation and the second variation.

## Description

### TECHNICAL FIELD

### CROSS-REFERENCE TO RELATED APPLICATION

This application claims priority to and the benefit of Korean Patent Application No. 10-2023-0183552 filed in the Korean Intellectual Property Office on December 15, 2023, the entire content of which is incorporated herein by reference.

### TECHNICAL FIELD

Embodiments disclosed herein relate to a battery diagnosis apparatus and an operating method thereof.

### BACKGROUND ART

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

When a micro internal short-circuit occurs in a battery cell, a current leakage may occur in the battery cell regardless of whether a battery is used. Thus, the battery cell having the micro internal short-circuit is self-discharged, and thus a voltage level thereof gradually decreases when compared to another battery cell in a battery pack. Moreover, as a short-circuit occurs in the battery cell having the micro internal short-circuit, proactive detection is important before the risk increases.

### DISCLOSURE

### TECHNICAL PROBLEM

Embodiments disclosed herein aim to provide a battery diagnosis apparatus and an operating method thereof, which are capable of solving a problem of difficult diagnosis due to a failure of self-discharge to reach a voltage deviation diagnosis level caused by a fine decrease of a voltage of a battery cell in case of a micro internal short-circuit.

Embodiments disclosed herein aim to provide a battery diagnosis apparatus and an operating method thereof in which short-term internal short-circuit diagnosis and long-term internal short-circuit diagnosis may be performed based on a voltage deviation between battery cells.

Technical problems of the embodiments disclosed herein are not limited to the above-described technical problems, and other unmentioned technical problems would be clearly understood by one of ordinary skill in the art from the following description.

### TECHNICAL SOLUTION

A battery diagnosis apparatus according to an embodiment disclosed herein includes an information obtaining unit configured to obtain a voltage of each of a plurality of battery cells, a voltage deviation calculating unit configured to calculate an average of voltages of the plurality of battery cells and calculate, as a first deviation, a difference between the average and the voltage of each of the plurality of battery cells, and a controller configured to calculate a first variation corresponding to a variation of a first deviation of each of the plurality of battery cells for each first period, calculate a second variation corresponding to a variation of the first deviation of each of the plurality of battery cells for each second period that is different from the first period, and perform abnormality diagnosis on the plurality of battery cells based on the first variation and the second variation.

In an embodiment, the controller may be further configured to perform different abnormality diagnosis on the plurality of battery cells based on each of the first variation and the second variation.

In an embodiment, the controller may be further configured to diagnose based on the first variation whether an internal short- circuit with rapid discharge occurs in each of the plurality of battery cells and diagnose based on the second variation whether a micro internal short-circuit occurs in each of the plurality of battery cells.

In an embodiment, the second period may be greater than or equal to the first period.

In an embodiment, the battery diagnosis apparatus may further include a storing unit configured to store a first reference deviation for the plurality of battery cells and a second reference deviation for the plurality of battery cells, in which the controller is further configured to calculate, as the first variation, a difference between the first reference deviation for the plurality of battery cells and the first deviation of each of the plurality of battery cells, for each first period and calculate, as the second variation, a difference between the second reference deviation for the plurality of battery cells and the first deviation of each of the plurality of battery cells, for each second period.

In an embodiment, the controller may be further configured to update the first reference deviation for the plurality of battery cells with the first deviation of each of the plurality of battery cells, for each second period.

In an embodiment, the second reference deviation for each of the plurality of battery cells may be a fixed value.

An operating method of a battery diagnosis apparatus, according to an embodiment disclosed herein includes obtaining a voltage of each of a plurality of battery cells, calculating an average of voltages of the plurality of battery cells and calculate, as a first deviation, a difference between the average and the voltage of each of the plurality of battery cells, calculating a first variation corresponding to a variation of a first deviation of each of the plurality of battery cells for each first period, calculating a second variation corresponding to a variation of the first deviation of each of the plurality of battery cells for each second period that is different from the first period, and performing abnormality diagnosis on the plurality of battery cells based on the first variation and the second variation.

In an embodiment, the performing of the abnormality diagnosis on the plurality of battery cells based on the first variation and the second variation may include performing different abnormality diagnosis on the plurality of battery cells based on each of the first variation and the second variation.

In an embodiment, the performing of the abnormality diagnosis on the plurality of battery cells based on the first variation and the second variation may include diagnosing based on the first variation whether an internal short- circuit with rapid discharge occurs in each of the plurality of battery cells and diagnosing based on the second variation whether a micro internal short-circuit occurs in each of the plurality of battery cells.

In an embodiment, the second period may be greater than or equal to the first period.

In an embodiment, the operating method may further include storing a first reference deviation for the plurality of battery cells and a second reference deviation for the plurality of battery cells, in which the calculating of the first variation corresponding to the variation of the first deviation of each of the plurality of battery cells for each first period includes calculating, as the first variation, a difference between the first reference deviation for the plurality of battery cells and the first deviation of each of the plurality of battery cells, for each first period, and the calculating of the second variation corresponding to the variation of the first deviation of each of the plurality of battery cells for each second period that is different from the first period includes calculating, as the second variation, a difference between the second reference deviation for the plurality of battery cells and the first deviation of each of the plurality of battery cells, for each second period.

In an embodiment, the operating method may further include updating the first reference deviation for the plurality of battery cells with the first deviation of each of the plurality of battery cells, for each second period.

In an embodiment, the second reference deviation for each of the plurality of battery cells may be a fixed value.

### ADVANTAGEOUS EFFECTS

A battery diagnosis apparatus and an operating method thereof according to an embodiment disclosed herein may diagnose a micro internal short-circuit of a battery cell that is self-discharged finely over a long term.

The battery diagnosis apparatus and the operating method thereof according to an embodiment disclosed herein may simultaneously diagnose a short-term internal short-circuit and a micro internal short-circuit of a battery cell based on a change of a voltage deviation between battery cells.

In addition, various effects identified directly or indirectly through this document may be provided.

### DESCRIPTION OF DRAWINGS

FIG. 1 is a block diagram showing a structure of a general battery pack.
FIG. 2 shows a battery diagnosis apparatus according to an embodiment disclosed herein.
FIG. 3 shows an example in which a battery diagnosis apparatus diagnoses a plurality of battery cells, according to an embodiment disclosed herein.
FIG. 4 is a flowchart showing an operating method of a battery diagnosis apparatus according to an embodiment disclosed herein.
FIG. 5 is a flowchart showing in detail an operating method of a battery diagnosis apparatus according to an embodiment disclosed herein.
FIG. 6 is a block diagram showing a hardware configuration of a computing system for performing an operating method of a battery diagnosis apparatus, according to an embodiment disclosed herein.

### MODE FOR INVENTION

Hereinafter, embodiments disclosed herein will be described in detail through exemplary drawings. In adding reference numerals to components of each drawing, it should be noted that the same components have the same numerals as much as possible even though they are displayed on different drawings. Moreover, in describing the embodiments disclosed herein, when it is determined that a detailed description of a related known configuration or function interferes with understanding of the embodiment disclosed herein, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. The terms defined in a generally used dictionary should be interpreted as having the same meanings as the contextual meanings of the relevant technology and should not be interpreted as having ideal or exaggerated meanings unless they are clearly defined in the present application.

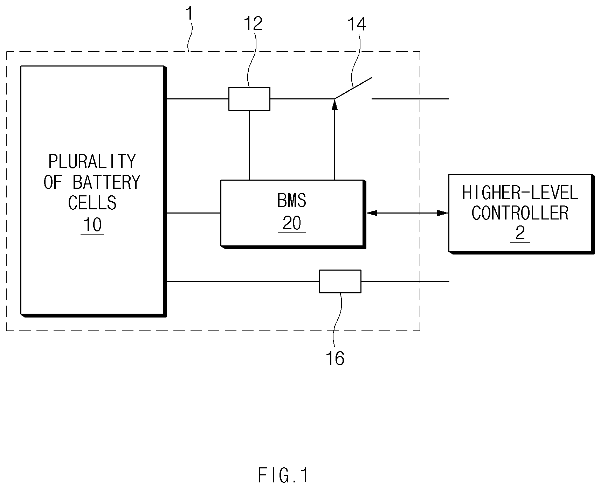

FIG. 1 is a block diagram showing a structure of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a plurality of battery cells 10 that include one or more battery cells and are chargeable/dischargeable, a switching unit 14 serially connected to positive (+) terminal sides or negative (-) terminal sides of the plurality of battery cells 10 to control a charging/discharging current flow of the plurality of battery cells 10, and a battery management system 20 for control and management to prevent over-charging and over-discharging by monitoring voltage, current, temperature, etc., of the battery pack 1. The battery pack 1 may include the plurality of battery cells 10, the sensor 12, the switching unit 14, and the battery management system 20 provided in plural.

Herein, as the switching unit 14 which is an element for controlling a current flow for charging or discharging of the plurality of battery cells 10, for example, at least one relay, magnetic contactor, etc., may be used according to specifications of the battery pack 1.

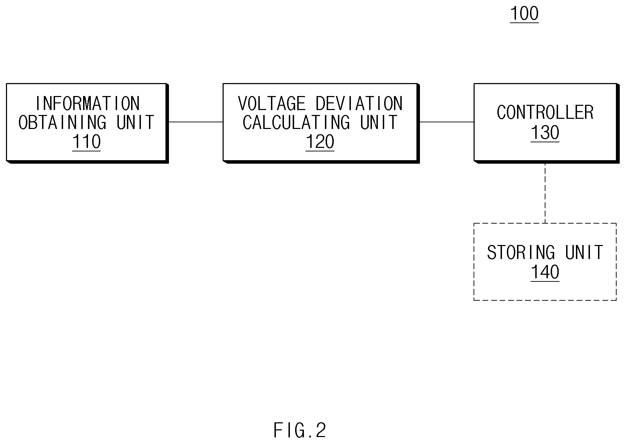

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the plurality of battery cells 10 to monitor the state of each battery cell 10. According to an embodiment, the battery management system 20 may include a battery diagnosis apparatus 100 of FIG. 2. According to another embodiment, the battery management system 20 may be different from the battery diagnosis apparatus 100 of FIG. 2. That is, the battery diagnosis apparatus 100 of FIG. 2 may be included in the battery pack 1 and may be configured as another device outside the battery pack 1. The following operation of the battery diagnosis apparatus 100 may also be performed in various devices such as not only a battery management system (BMS) in a vehicle, but also a server, a cloud, a charger, a charger/discharger, etc.

The higher-level controller 2 may transmit a control signal regarding the plurality of battery cells 10 to the battery management system 20. Thus, the battery management system 20 may also be controlled in terms of an operation thereof based on a signal applied from the higher-level controller 2.

FIG. 2 shows a battery diagnosis apparatus according to an embodiment disclosed herein.

The battery diagnosis apparatus 100 may be one of various electronic devices for managing, diagnosing, or testing a battery. For example, the battery diagnosis apparatus 100 may be included in a BMS in a vehicle, or may be implemented as a separate external device different from the BMS in the vehicle.

According to another embodiment, the battery diagnosis apparatus 100 may be included in an apparatus for a charging/discharging test such as a server, a cloud server, or a charging/discharging cycler or may be included in various devices for diagnosing or testing the battery.

Referring to FIG. 2, the battery diagnosis apparatus 100 may include an information obtaining unit 110, a voltage deviation calculating unit 120, and a controller 130. According to an embodiment, the battery diagnosis apparatus 100 may further include a storing unit 140.

The information obtaining unit 110 may obtain a voltage of each of the plurality of battery cells. For example, the information obtaining unit 110 may obtain a voltage of each of the plurality of battery cells at preset intervals. In another example, the information obtaining unit 110 may obtain an open circuit voltage of each of the plurality of battery cells.

According to an embodiment, the information obtaining unit 110 may obtain an open circuit voltage of each of the plurality of battery cells at intervals of a first period and an open circuit voltage of each of the plurality of battery cells at intervals of a second period. For example, the first period may be one day and the second period may be 30 days, but the present disclosure is not limited thereto.

According to an embodiment, the second period may be an integer multiple of the first period.

The voltage deviation calculating unit 120 may calculate an average of voltages of the plurality of battery cells. For example, the voltage deviation calculating unit 120 may calculate the average of the voltages of the plurality of battery cells at a preset point in time.

The voltage deviation calculating unit 120 may calculate, as a first deviation, a difference between the calculated average and the voltage of each of the plurality of battery cells. For example, the voltage deviation calculating unit 120 may calculate the first deviation for each of the plurality of battery cells.

According to an embodiment, the voltage deviation calculating unit 120 may receive the preset time and the voltage of each of the plurality of battery cells, calculate the first deviation of each of the plurality of battery cells, and correspond the first deviation to the preset time. The voltage deviation calculating unit 120 may transmit the first deviation of each of the plurality of battery cells corresponding to the preset time to the controller 130.

According to an embodiment, the voltage deviation calculating unit 120 may be included in the controller 130. According to another embodiment, an operation of the voltage deviation calculating unit 120 may be performed by the controller 130.

The controller 130 may calculate a first variation corresponding to a variation of the first deviation of each of the plurality of battery cells for each first period. The controller 130 may also calculate a second variation corresponding to the variation of the first deviation of each of the plurality of battery cells for each second period that is different from the first period. For example, the first period may be one day and the second period may be 30 days, but the present disclosure is not limited thereto. According to an embodiment, the second period may be greater than or equal to the first period.

The controller 130 may diagnose abnormality of the plurality of battery cells based on the first variation and the second variation. For example, the controller 130 may perform different abnormality of diagnosis of the plurality of battery cells based on the first variation and the second variation. That is, the controller 130 may perform first abnormality diagnosis on the plurality of battery cells based on the first variation and perform second abnormality diagnosis on the plurality of battery cells based on the second variation.

According to an embodiment, the controller 130 may diagnose based on the first variation whether an internal short- circuit with rapid discharge occurs in each of the plurality of battery cells. The controller 130 may also diagnose based on the second variation whether a micro internal short-circuit occurs in each of the plurality of battery cells. That is, the controller 130 may diagnose a rapid internal short-circuit based on the first variation of the first deviation for the first period and diagnose a micro internal short-circuit based on the second variation of the first deviation for the second period that is longer than the first period.

The storing unit 140 may store a first reference deviation for the plurality of battery cells and a second reference deviation for the plurality of battery cells. For example, the first reference deviation may be a value used in calculation of the first variation and the second reference deviation may be a value used in calculation of the second variation. For example, the second reference deviation may be a fixed value. According to an embodiment, the second reference deviation may be a value set in production of a battery and fixed until disposal of the battery.

According to an embodiment, the first reference deviation may be set as the first deviation of each of the plurality of battery cells at a specific point in time. For example, the first reference deviation may be set as the first deviation of each of the plurality of battery cells at a first diagnosis point in time.

According to an embodiment, the first reference deviation may be updated as the first deviation of each of the plurality of battery cells at a corresponding point for each preset period. For example, the first reference deviation may be updated as the first deviation of the plurality of battery cells at a corresponding point in time for each second period.

The controller 130 may calculate, as the first variation, a difference between the first reference deviation for the plurality of battery cells and the first deviation of each of the plurality of battery cells for each first period. The controller 130 may also calculate, as the second variation, a difference between the second reference deviation for the plurality of battery cells and the first deviation of each of the plurality of battery cells for each second period.

According to an embodiment, the controller 130 may diagnose that an internal short-circuit occurs in a battery cell having a first variation being at least a first threshold value among the plurality of battery cells.

According to an embodiment, the controller 130 may diagnose that a micro internal short-circuit occurs in a battery cell having a second variation being at least a second threshold value among the plurality of battery cells.

The battery diagnosis apparatus 100 according to an embodiment disclosed herein may diagnose a micro internal short-circuit of a battery cell that is self-discharged finely over a long term.

The battery diagnosis apparatus 100 according to an embodiment disclosed herein may simultaneously diagnose a short-term internal short-circuit and a micro internal short-circuit of a battery cell based on a change of a voltage deviation between battery cells.

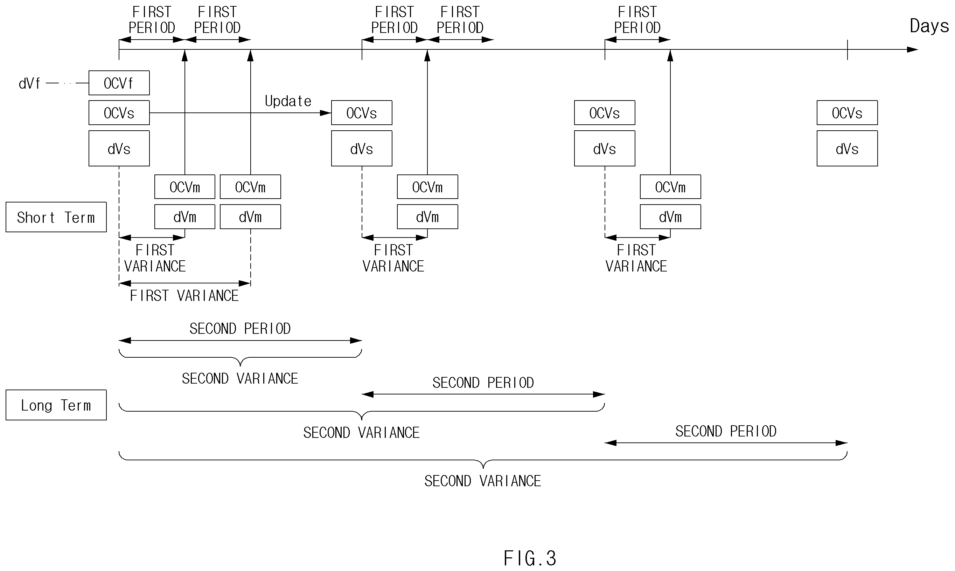

FIG. 3 shows an example in which a battery diagnosis apparatus diagnoses a plurality of battery cells, according to an embodiment disclosed herein.

Referring to FIG. 3, the information obtaining unit 110 of the battery diagnosis apparatus 100 may obtain voltages (OCVf, OCVs, etc.) of a plurality of battery cells.

The voltage deviation calculating unit 120 may calculate an average of voltages OCVm of the plurality of battery cells and calculate, as a first deviation (dVs, dVm), a difference between the average and the voltage OCVs or OCVm of each of the plurality of battery cells.

The voltage OCVf of each of the plurality of battery cells, obtained first, may be stored in the storing unit 140. The storing unit 140 may store the second reference deviation for each of the plurality of battery cells, calculated based on the voltage OCVf of each of the plurality of battery cells, obtained first. For example, the second reference deviation may be calculated as a difference between the average of the voltage OCVf of each of the plurality of battery cells, obtained first, and the voltage OCVf of each of the plurality of battery cells, obtained first.

The storing unit 140 may store a first reference deviation dVs. For example, the first reference deviation dVs may be updated for each preset period. In another example, the first reference deviation dVs may be calculated based on the voltage OCVs of each of the plurality of battery cells at a preset point in time. For example, the first reference deviation dVs may be calculated as a difference between the average of the voltage OCVs of each of the plurality of battery cells at a preset point in time and the voltage OCVs of each of the plurality of battery cells at the preset point in time. According to an embodiment, the first reference deviation dVs may be updated for each second period.

The controller 130 may calculate the first variation corresponding to the variation of the first deviation of the plurality of battery cells for each first period. For example, the controller 130 may calculate, as the first variation, a difference between the first deviation dVm of the plurality of battery cells and the first reference deviation dVs, for each first period.

The controller 130 may diagnose each of the plurality of battery cells based on the first variation. For example, the controller 130 may diagnose that an internal short-circuit occurs in a battery cell having a first variation being at least the first threshold value (e.g., 10 mV).

The controller 130 may calculate the second variation corresponding to the first deviation of the plurality of battery cells for each second period. For example, the controller 130 may calculate the second variation based on a difference between the first deviation dVs of the plurality of battery cells and the second reference deviation dVf, for each second period.

The controller 130 may diagnose each of the plurality of battery cells based on the second variation. For example, the controller 130 may diagnose that a micro internal short-circuit occurs in a battery cell having a second variation being at least the second threshold value (e.g., 10 mV).

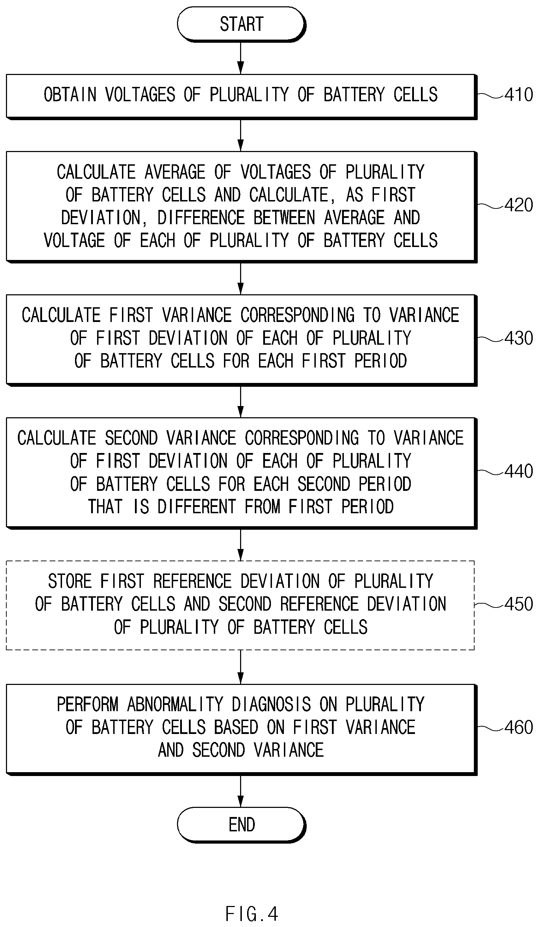

FIG. 4 is a flowchart showing an operating method of a battery diagnosis apparatus according to an embodiment disclosed herein. According to an embodiment, operations shown in FIG. 4 may be performed by the battery diagnosis apparatus 100 of FIG. 2.

Referring to FIG. 4, in operation 410, the information obtaining unit 110 may obtain a voltage of a plurality of battery cells. For example, the information obtaining unit 110 may obtain a voltage of each of the plurality of battery cells at preset intervals. In another example, the information obtaining unit 110 may obtain an open circuit voltage of each of the plurality of battery cells.

According to an embodiment, the information obtaining unit 110 may obtain an open circuit voltage of each of the plurality of battery cells at intervals of a first period and an open circuit voltage of each of the plurality of battery cells at intervals of a second period. For example, the first period may be one day and the second period may be 30 days, but the present disclosure is not limited thereto.

In operation 420, the voltage deviation calculating unit 120 may calculate an average of voltages of the plurality of battery cells. For example, the voltage deviation calculating unit 120 may calculate the average of the voltages of the plurality of battery cells at a preset point in time.

The voltage deviation calculating unit 120 may calculate, as the first deviation, a difference between the calculated average and the voltage of each of the plurality of battery cells. For example, the voltage deviation calculating unit 120 may calculate the first deviation for each of the plurality of battery cells.

In operation 430, the controller 130 may calculate the first variation corresponding to a variation of the first deviation of each of the plurality of battery cells for each first period.

In operation 440, the controller 130 may also calculate the second variation corresponding to the variation of the first deviation of each of the plurality of battery cells for each second period that is different from the first period. For example, the first period may be one day and the second period may be 30 days, but the present disclosure is not limited thereto. According to an embodiment, the second period may be greater than or equal to the first period.

In operation 450, the storing unit 140 may store the first reference deviation for the plurality of battery cells and the second reference deviation for the plurality of battery cells. For example, the first reference deviation for the plurality of battery cells and the second reference deviation for the plurality of battery cells may be values stored in the storing unit 140 and may be calculated by the controller 130 and stored. According to an embodiment, operation 450 may be omitted. In another example, the first reference deviation may be a value used in calculation of the first variation and the second reference deviation may be a value used in calculation of the second variation. For example, the second reference deviation may be a fixed value. According to an embodiment, the second reference deviation may be a value set in production of a battery and fixed until disposal of the battery.

According to an embodiment, the first reference deviation may be set as the first deviation of each of the plurality of battery cells at a specific point in time. For example, the first reference deviation may be set as the first deviation of each of the plurality of battery cells at a first diagnosis point in time.

According to an embodiment, the first reference deviation may be updated as the first deviation of each of the plurality of battery cells at a corresponding point for each preset period. For example, the first reference deviation may be updated as the first deviation of the plurality of battery cells at a corresponding point in time for each second period.

In operation 460, the controller 130 may diagnose abnormality of the plurality of battery cells based on the first variation and the second variation. For example, the controller 130 may perform different abnormality of diagnosis of the plurality of battery cells based on the first variation and the second variation. That is, the controller 130 may perform first abnormality diagnosis on the plurality of battery cells based on the first variation and perform second abnormality diagnosis on the plurality of battery cells based on the second variation.

According to an embodiment, the controller 130 may diagnose based on the first variation whether an internal short- circuit with rapid discharge occurs in each of the plurality of battery cells. The controller 130 may also diagnose based on the second variation whether a micro internal short-circuit occurs in each of the plurality of battery cells. That is, the controller 130 may diagnose a rapid internal short-circuit based on the first variation of the first deviation for the first period and diagnose a micro internal short-circuit based on the second variation of the first deviation for the second period that is longer than the first period.

According to an embodiment, the controller 130 may calculate, as the first variation, a difference between the first reference deviation for the plurality of battery cells and the first deviation of each of the plurality of battery cells for each first period. The controller 130 may also calculate, as the second variation, a difference between the second reference deviation for the plurality of battery cells and the first deviation of each of the plurality of battery cells for each second period.

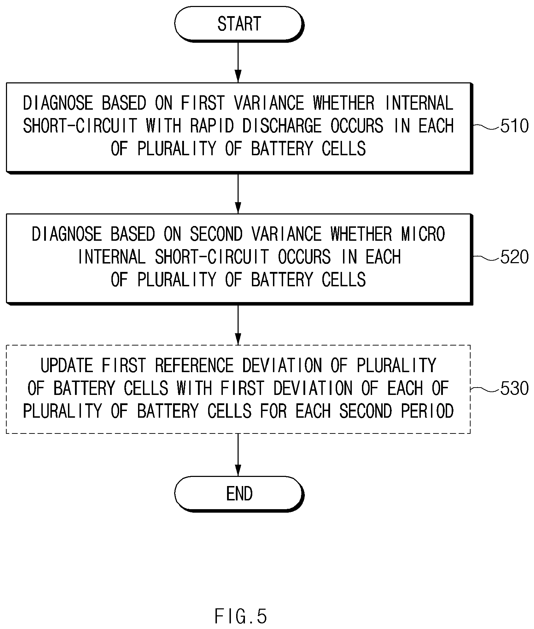

FIG. 5 is a flowchart showing in detail an operating method of a battery diagnosis apparatus according to an embodiment disclosed herein. According to an embodiment, operations shown in FIG. 5 may be performed by the battery diagnosis apparatus 100 of FIG. 2.

Referring to FIG. 5, in operation 510, the controller 130 may diagnose based on the first variation whether an internal short- circuit with rapid discharge occurs in each of the plurality of battery cells. For example, the controller 130 may diagnose that an internal short-circuit occurs in a battery cell having a first variation being at least the first threshold value among the plurality of battery cells.

In operation 520, the controller 130 may also diagnose based on the second variation whether a micro internal short-circuit occurs in each of the plurality of battery cells. For example, the controller 130 may diagnose that a micro internal short-circuit occurs in a battery cell having a second variation being at least the second threshold value among the plurality of battery cells.

In operation 530, the controller 130 may update the first reference deviation for the plurality of battery cells with the first deviation of each of the plurality of battery cells, for each second period.

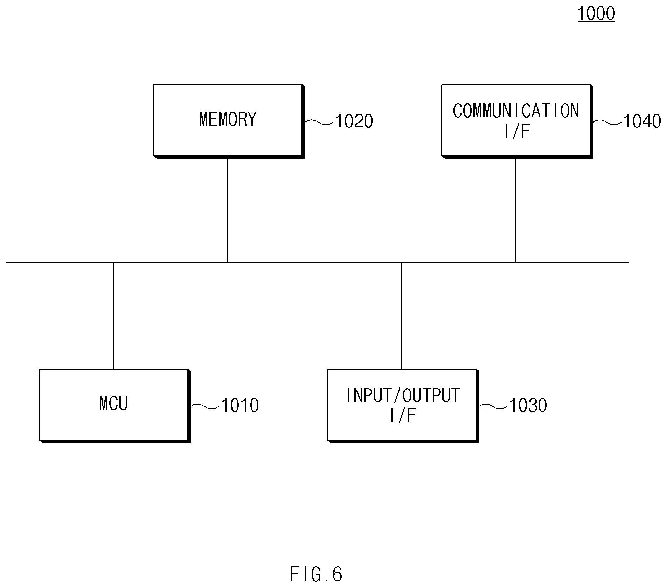

FIG. 6 is a block diagram showing a hardware configuration of a computing system for performing an operating method of a battery diagnosis apparatus, according to an embodiment disclosed herein.

Referring to FIG. 6, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs (e.g., a plurality of battery cell voltage measurement programs, a plurality of battery cell voltage deviation calculation programs, a plurality of battery cell diagnosis programs, etc.) stored in the memory 1020, processes various information including voltages of the plurality of battery cells, voltage deviations of the plurality of battery cells, internal short-circuits of the plurality of battery cells, etc.) through these programs, and causes functions of a controller included in the battery diagnosis apparatus shown in FIG. 2 to be executed.

The memory 1020 may store various programs such as the plurality of battery cell voltage measurement programs, the plurality of battery cell voltage deviation calculation programs, the plurality of battery cell diagnosis programs, etc. The memory 1020 may also store various information including the voltages of the plurality of battery cells, the voltage deviations of the plurality of battery cells, the internal short-circuits of the plurality of battery cells, etc.

The memory 1020 may be provided in plural, depending on a need. The memory 1020 may be a volatile or nonvolatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., with the MCU 1010.

The communication I/F 1040, which is a component capable of transmitting and receiving various data to and from a server, may be various types of devices capable of supporting wired or wireless communication. For example, the battery diagnosis apparatus may transmit and receive various information including the voltages of the plurality of battery cells, the voltage deviations of the plurality of battery cells, the internal short-circuits of the plurality of battery cells, etc., to and from a separately provided external server through the communication I/F 1040.

As such, a computer program according to an embodiment disclosed herein may be recorded in the memory 1020 and processed by the MCU 1010, thus being implemented as a module that performs functions shown in FIG. 2.

The above description is merely illustrative of the technical idea disclosed herein, and various modifications and variations will be possible without departing from the essential characteristics of the embodiments disclosed herein by those of ordinary skill in the art to which the embodiments disclosed herein pertains.

Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

### List of Reference Numerals for Major Elements

100: BATTERY DIAGNOSIS APPARATUS
110: INFORMATION OBTAINING UNIT
120: VOLTAGE DEVIATION CALCULATING UNIT
130: CONTROLLER
120: STORING UNIT
1000: COMPUTING SYSTEM
1010: MCU
1020: MEMORY
1030: INPUT/OUTPUT I/F
1040: COMMUNICATION I/F

## Claims

1. A battery diagnosis apparatus comprising:
an information obtaining unit configured to obtain a voltage of each of a plurality of battery cells;
a voltage deviation calculating unit configured to calculate an average of voltages of the plurality of battery cells and calculate, as a first deviation, a difference between the average and the voltage of each of the plurality of battery cells; and
a controller configured to:
calculate a first variation corresponding to a variation of a first deviation of each of the plurality of battery cells for each first period;
calculate a second variation corresponding to a variation of the first deviation of each of the plurality of battery cells for each second period that is different from the first period; and
perform abnormality diagnosis on the plurality of battery cells based on the first variation and the second variation.

2. The battery diagnosis apparatus of claim 1, wherein the controller is further configured to perform different abnormality diagnosis on the plurality of battery cells based on each of the first variation and the second variation.

3. The battery diagnosis apparatus of claim 2, wherein the controller is further configured to:
diagnose based on the first variation whether an internal short- circuit with rapid discharge occurs in each of the plurality of battery cells; and
diagnose based on the second variation whether a micro internal short-circuit occurs in each of the plurality of battery cells.

4. The battery diagnosis apparatus of claim 1, wherein the second period is greater than or equal to the first period.

5. The battery diagnosis apparatus of claim 1, further comprising a storing unit configured to store a first reference deviation for the plurality of battery cells and a second reference deviation for the plurality of battery cells,
wherein the controller is further configured to:
calculate, as the first variation, a difference between the first reference deviation for the plurality of battery cells and the first deviation of each of the plurality of battery cells, for each first period; and
calculate, as the second variation, a difference between the second reference deviation for the plurality of battery cells and the first deviation of each of the plurality of battery cells, for each second period.

6. The battery diagnosis apparatus of claim 5, wherein the controller is further configured to update the first reference deviation for the plurality of battery cells with the first deviation of each of the plurality of battery cells, for each second period.

7. The battery diagnosis apparatus of claim 5, wherein the second reference deviation for each of the plurality of battery cells is a fixed value.

8. An operating method of a battery diagnosis apparatus, the operating method comprising:
obtaining a voltage of each of a plurality of battery cells;
calculating an average of voltages of the plurality of battery cells and calculate, as a first deviation, a difference between the average and the voltage of each of the plurality of battery cells;
calculating a first variation corresponding to a variation of a first deviation of each of the plurality of battery cells for each first period;
calculating a second variation corresponding to a variation of the first deviation of each of the plurality of battery cells for each second period that is different from the first period; and
performing abnormality diagnosis on the plurality of battery cells based on the first variation and the second variation.

9. The operating method of claim 9, wherein the performing of the abnormality diagnosis on the plurality of battery cells based on the first variation and the second variation comprises performing different abnormality diagnosis on the plurality of battery cells based on each of the first variation and the second variation.

10. The operating method of claim 10, wherein the performing of the abnormality diagnosis on the plurality of battery cells based on the first variation and the second variation comprises:
diagnosing based on the first variation whether an internal short- circuit with rapid internal short-circuit occurs in each of the plurality of battery cells; and
diagnosing based on the second variation whether a micro internal short-circuit occurs in each of the plurality of battery cells.

11. The operating method of claim 9, wherein the second period is greater than or equal to the first period.

12. The operating method of claim 9, further comprising storing a first reference deviation for the plurality of battery cells and a second reference deviation for the plurality of battery cells,
wherein the calculating of the first variation corresponding to the variation of the first deviation of each of the plurality of battery cells for each first period comprises calculating, as the first variation, a difference between the first reference deviation for the plurality of battery cells and the first deviation of each of the plurality of battery cells, for each first period, and
the calculating of the second variation corresponding to the variation of the first deviation of each of the plurality of battery cells for each second period that is different from the first period comprises calculating, as the second variation, a difference between the second reference deviation for the plurality of battery cells and the first deviation of each of the plurality of battery cells, for each second period.

13. The operating method of claim 12, further comprising updating the first reference deviation for the plurality of battery cells with the first deviation of each of the plurality of battery cells, for each second period.

14. The operating method of claim 12, wherein the second reference deviation for each of the plurality of battery cells is a fixed value.
